Europäisches Patentamt

European Patent Office

Office européen des brevets

(19)

(11) **EP 0 578 562 B1**

(12) **FASCICULE DE BREVET EUROPEEN**

(45) Date de publication et mention
de la délivrance du brevet:
**29.04.1998   Bulletin 1998/18**

(51) Int Cl.6: **G03F 7/207**, G03F 7/20

(21) Numéro de dépôt: 93401751.8

(22) Date de dépôt: 06.07.1993

(54) **Procédé de détermination de la mise au point d'une machine d'exposition photolithographique**

Verfahren zur Bestimmung der Scharfeinstellung einer photolithographischen Belichtungsvorrichtung

Procedure for determining the focus of a photolithographic exposure apparatus

(84) Etats contractants désignés:
DE GB NL

(30) Priorité:  **10.07.1992  FR 9208610**

(43) Date de publication de la demande:
**12.01.1994   Bulletin 1994/02**

(73) Titulaire: **FRANCE TELECOM**
**75015 Paris (FR)**

(72) Inventeurs:
 • **Minghetti, Blandine**
   **F-38410 Vaulnaveys le Haut (FR)**
 • **Tissier, Annie**
   **F-38330 Saint Ismier (FR)**
 • **Prola, Alain**
   **F-38100 Grenoble (FR)**
 • **Schwartz, Eric**
   **F-38180 Seyssins (FR)**

(74) Mandataire: **Fort, Jacques et al**
**CABINET PLASSERAUD**
**84, rue d'Amsterdam**
**75440 Paris Cedex 09 (FR)**

(56) Documents cités:
**EP-A- 0 267 721        EP-A- 0 378 033**

 • **MICROELECTRONIC ENGINEERING vol. 9, no.**
   **1-4, Mai 1989, AMSTERDAM NL pages 79 - 82 ,**
   **XP34144 B. HUYNH ET AL. 'CALIBRATED**
   **EXPOSURE AND FOCUS TEST PATTERNS FOR**
   **CHARACTERIZATION OF OPTICAL**
   **PROJECTION PRINTING'**

# Description

L'invention est relative à un procédé de réglage d'une machine d'exposition photolithographique et au dispositif associé.

Lors de l'utilisation des machines d'exposition photolithographiques actuelles, plus communément appelées photorépéteurs, un souci constant est l'amélioration ou le maintien de la qualité du réglage de la résolution optique, afin d'obtenir des motifs exposés sur la surface d'une plaquette de circuit intégré revêtu d'une résine d'une qualité correspondante. De manière classique, l'amélioration de la résolution des photorépéteurs peut être effectuée soit en utilisant des lentilles à plus forte ouverture numérique, soit en réduisant la longueur d'onde de la lumière d'exposition.

Toutefois, les processus d'amélioration précités ont pour inconvénient de dégrader la profondeur de champ, DOF, proportionnelle à $\lambda/NA^2$, la résolution, R, étant proportionnelle à $\lambda/NA$, où $\lambda$ désigne la longueur d'onde de la lumière d'exposition, et NA l'ouverture numérique de la lentille utilisée.

En outre, le réglage du système optique de focalisation de la lumière sur la surface de la résine dépend de la température ambiante et de la pression atmosphérique. Des corrections automatiques ou conduites par logiciel peuvent être envisagées. Toutefois, ce type de correction est insuffisamment précis pour des profondeurs de champ de l'ordre du micromètre.

Un réglage au moins journalier s'avère donc nécessaire. Les méthodes couramment utilisées afin d'effectuer de tels réglages, très délicats, sont basées, soit sur des observations visuelles au microscope, soit sur des mesures dimensionnelles, avec ou sans clivage, permettant l'obtention du profil du trait de résine.

De telles méthodes présentent cependant des inconvénients majeurs tels que la forte dépendance de l'observation visuelle vis-à-vis de l'opérateur et le caractère particulièrement long et souvent destructeur en ce qui concerne les méthodes dimensionnelles.

Une autre méthode a été récemment proposée par la demande de brevet EP-A- 0 378 033. Cette méthode consiste à insoler la résine par un motif de test successivement en différents emplacements, une mise au point différente étant effectuée pour chaque insolation. Après développement, un fluage de la résine est effectué, puis la plaquette est examinée pour déterminer l'insolation optimale et adopter le réglage correspondant pour la machine. Cette méthode, bien que donnant satisfaction, présente l'inconvénient de nécessiter une étape de fluage dont la précision des effets reste peu précise. Les effets du fluage étant difficiles à optimiser.

La présente invention a pour but de remédier aux inconvénients des méthodes antérieures précitées.

Elle a pour objet un procédé et un dispositif de détermination de la mise au point d'une machine d'exposition photolithographique utilisée pour insoler des structures sur un substrat revêtu d'une résine formant masque, à partir d'une plaquette témoin munie de motifs de test identiques en différents emplacements.

Le procédé et le dispositif objets de l'invention sont remarquables en ce qu'ils consistent à, respectivement permettent de, illuminer successivement les motifs de test en lumière blanche au niveau de chaque emplacement, au moyen d'un faisceau d'illumination, oblique de préférence, mesurer le coefficient de réflectivité de chaque motif de test, puis, établir la loi de correspondance du coefficient de réflectivité en fonction, pour chaque emplacement, de la valeur du paramètre de défocalisation ou de mise au point du faisceau d'illumina-tion et déterminer par critère de seuil de la valeur du coefficient de réflectivité, une plage de valeurs correspondantes de défocalisation pour le motif de test considéré, permettant d'établir la valeur de mise au point optimale.

Le procédé et le dispositif objets de la présente invention trouvent application à l'industrie de la production des circuits intégrés. Ils seront mieux compris à la lecture de la description et à l'observation des dessins ci-après dans lesquels :

- la figure 1a représente, sous forme d'un schéma synoptique, les différentes étapes de mise en oeuvre du procédé objet de la présente invention,
- la figure 1b représente également sous forme d'un schéma synoptique, un mode de réalisation avantageux d'étapes particulières du procédé selon l'invention tel que représenté en figure 1a,
- la figure 1c représente, d'une part, la loi de correspondance du coefficient de réflectivité d'une plaquette témoin spécialement conçue pour la mise en oeuvre du procédé objet de l'invention en fonction de la défocalisation relative du faisceau d'illumination et/ou d'insolation, et, d'autre part, des profils de gravure remarquable pour différentes zones de valeurs de défocalisation,
- la figure 2a représente, en coupe, un échantillonnage photograhique du profil de trous formés dans une couche de résine d'une plaquette témoin pour des valeurs successives discrètes de défocalisation du faisceau d'insolation,
- la figure 2b représente, en coupe, le profil de sillons formés dans une couche de résine d'une plaquette substrat pour des valeurs différentes de défocalisation du faisceau d'insolation,
- la figure 3 représente, sous forme de schéma synoptique, un dispositif permettant la mise en oeuvre du procédé objet de la présente invention,
- la figure 4 représente un détail de certains éléments constitutifs du dispositif représenté en figure 3,
- la figure 5a représente en perspective une plaquette témoin spécialement adaptée pour la mise en oeuvre du procédé objet de l'invention,
- la figure 5b représente en coupe selon les plans $A_1 A_1$, $A_2 A_2$, $A_3 A_3$ de la figure 5a, un échantillonnage photographique du profil des trous au niveau de chaque motif de test constituant la plaquette témoin.

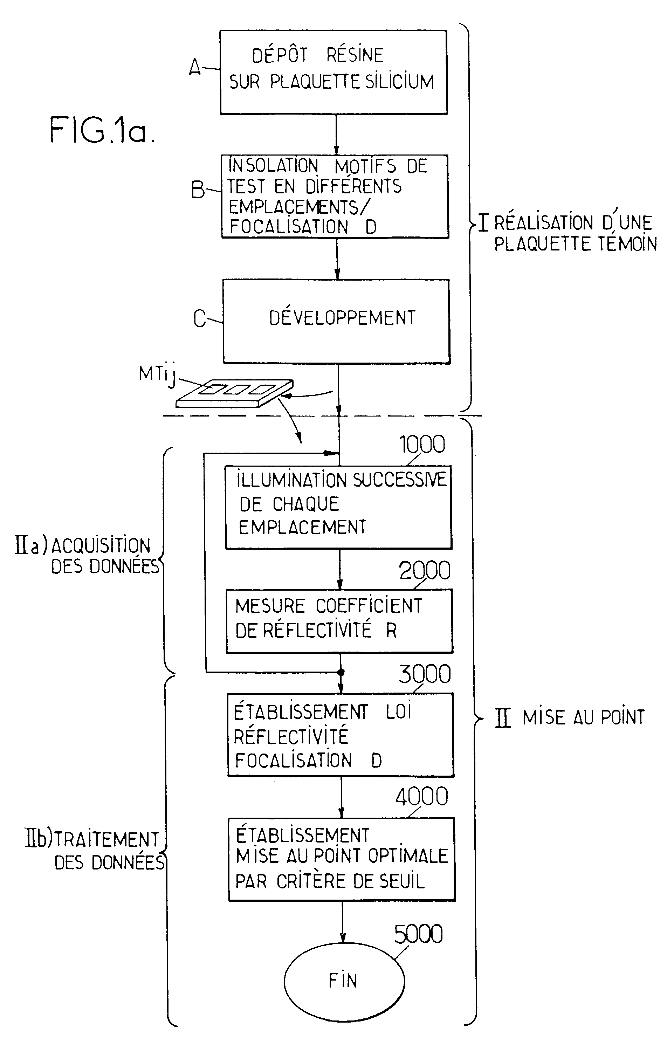

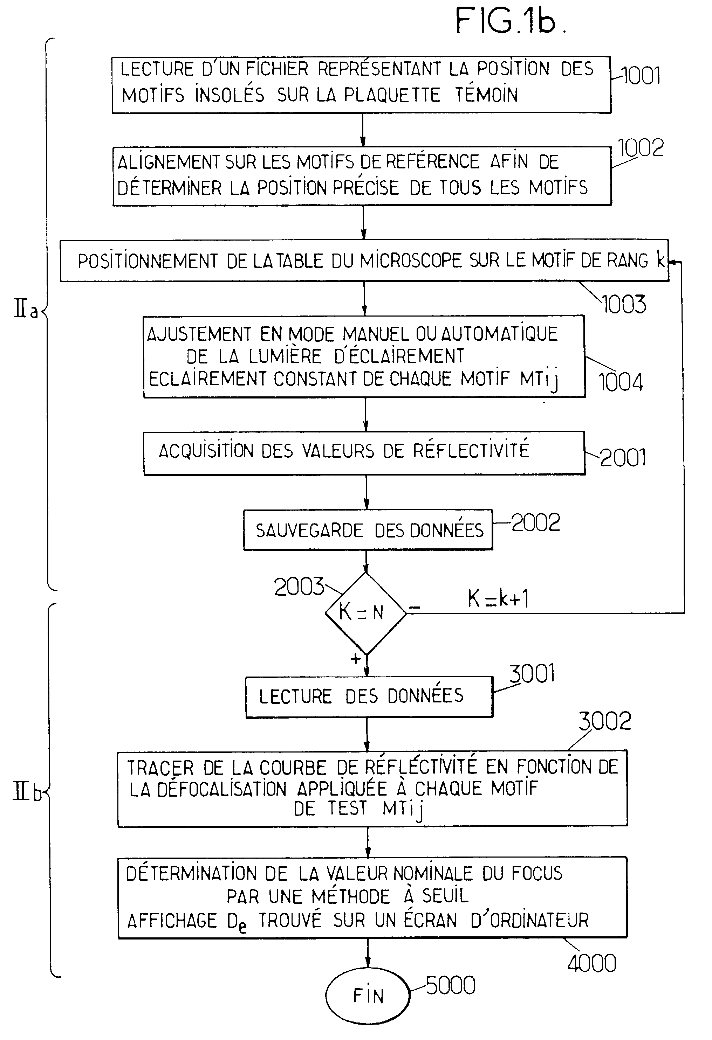

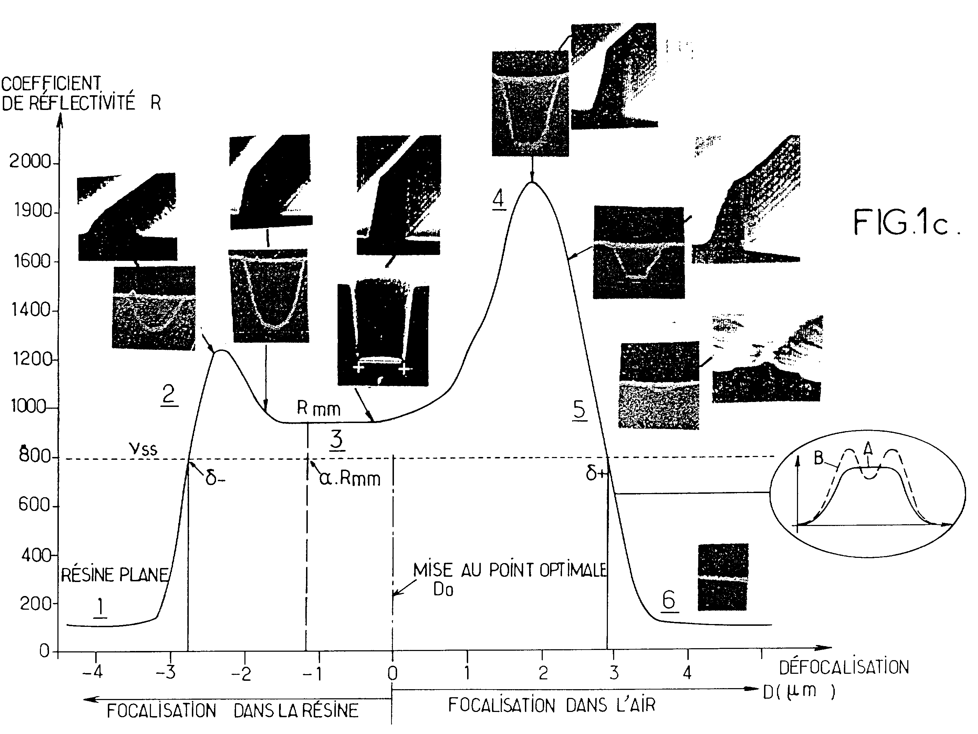

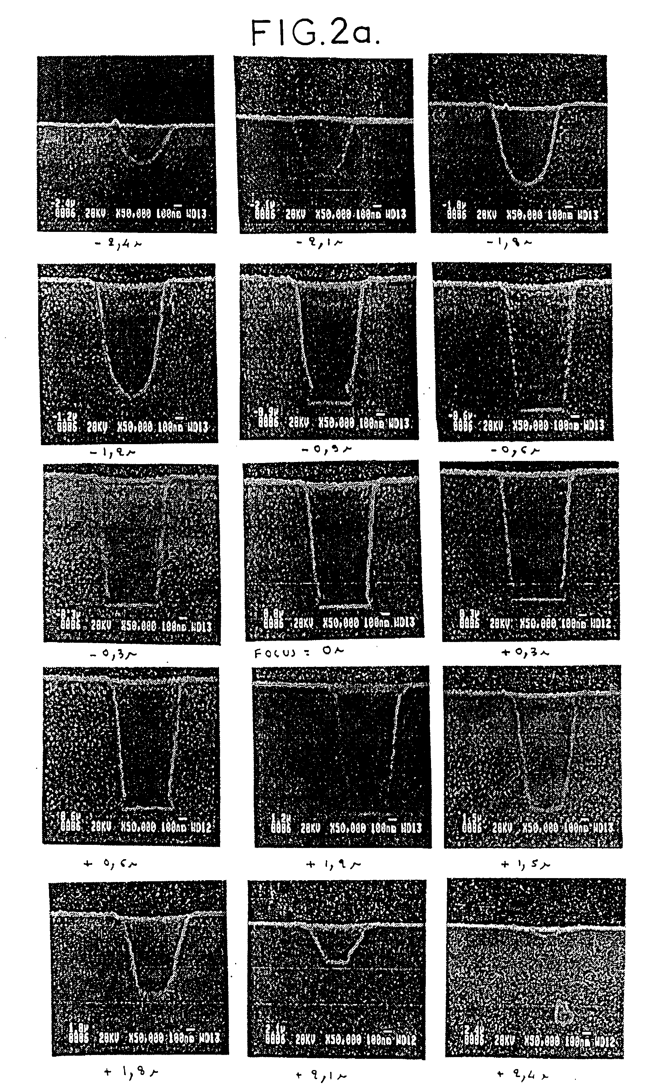

Une description plus détaillée du procédé de réglage d'une machine d'exposition photolithographique et du dispositif associé correspondant sera donnée en liaison avec les figures 1a, 1b, 1c et suivantes.

D'une manière générale, on considère que le procédé de réglage objet de la présente invention permet en fait de déterminer la mise au point optimale d'une machine d'exposition photolithographique utilisée pour insoler les structures sur une plaquette substrat revêtue d'une résine formant masque photosensible.

On comprend en effet que ce type de machine est utilisé pour la fabrication de circuits intégrés, et, en particulier l'insolation, des couches successives de ces derniers.

D'une manière plus spécifique, le procédé objet de la présente invention est mis en oeuvre à partir d'une plaquette témoin, notée Pt, munie de motifs de test identiques en différents emplacements et arrangés selon une suite de motifs de test.

Une description plus détaillée de la plaquette témoin Pt permettant la mise en oeuvre du procédé objet de l'invention sera donnée ultérieurement dans la description, le caractère d'identité des motifs de test étant en particulier précisé.

Sur la figure 1a, on a représenté de manière schématique les différentes étapes du procédé objet de la présente invention. Ainsi que représenté sur la figure précitée, le procédé selon l'invention peut être subdivisé en deux grandes étapes, une première étape, notée I, consistant en la réalisation d'une plaquette témoin, Pt, et consistant, ainsi que représenté sur la figure précitée, en trois étapes successives A, B, C, cette étape de réalisation d'une plaquette témoin n'étant pas considérée, à proprement parler, comme faisant partie du procédé objet de l'invention. En effet, l'étape I de réalisation d'une plaquette témoin est indiquée à titre illustratif, la plaquette témoin, Pt, obtenue suite à la mise en oeuvre des étapes A, B, C, constitutives de l'étape I de réalisation d'une plaquette témoin, étant ensuite utilisée pour la mise en oeuvre du procédé proprement dit.

Ainsi qu'on l'observera sur la figure 1a précitée, l'étape I de réalisation d'une plaquette témoin peut consister en une première étape A, consistant à déposer une couche de résine sur une plaquette de silicium, suivie d'une étape B d'insolation de motifs de test en différents emplacements, ces motifs de test étant arrangés selon une suite de motifs de test, et l'insolation étant réalisée pour chaque motif de test avec une focalisation de l'image du motif, sur la résine, différente pour chaque motif de test. On comprendra en particulier que la focalisation de l'image du motif sur la surface de la résine, c'est-à-dire sur l'interface air-résine, est une focalisation relative, laquelle doit être comprise comme réglée par un paramètre de défocalisation D par rapport à l'interface air-résine précitée.

L'étape B précédemment mentionnée est alors suivie d'une étape de développement, notée C, laquelle permet, après développement de la résine photosensible, d'obtenir la plaquette témoin Pt munie de sa suite de motifs de test. Sur la figure 1a, on a ainsi représenté la plaquette témoin Pt, munie de ses différents motifs de test, notés $Mt_{ij}$. On notera que les indices i, j permettent de repérer les adresses successives de chaque motif de test, et en particulier, leur position, ainsi qu'il sera décrit ultérieurement dans la description.

Ainsi qu'on l'observera en outre sur la figure 1a, le procédé objet de la présente invention consiste alors en une étape 1000 à illuminer successivement les motifs de test $MT_{ij}$ en lumière blanche au niveau de chaque emplacement d'adresse i,j, au moyen d'un faisceau d'illumination.

L'étape 1000 précitée est suivie d'une étape 2000 consistant à mesurer le coefficient de réflectivité de chaque motif de test $MT_{ij}$. On comprend bien sûr que l'étape 1000 d'illumination étant effectuée, pour un motif de test d'adresse i,j donnée, l'étape 2000 de mesure du coefficient de réflectivité est effectuée immédiatement pour ce motif de test considéré et la succession des étapes 1000 et 2000 précédemment mentionnée est répétée pour chaque motif de test, la répétition étant symbolisée sur la figure 1a par la boucle de retour en amont de l'étape 1000. Bien entendu, les données relatives à la mesure du coefficient de réflectivité R obtenues à l'étape 2000 sont mémorisées et la succession des étapes 1000 et 2000 répétées pour chaque motif de test constitue ainsi une étape d'acquisition des données, notée IIa, sur la figure 1a. L'étape d'acquisition des données IIa précédemment mentionnée est alors suivie d'une étape IIb de traitement de ces données. L'étape de traitement des données comprend, ainsi que représenté sur la figure 1a, une première étape 3000 consistant à établir la loi de correspondance du coefficient de réflectivité R pour chaque emplacement ou motif de test $MT_{ij}$ en fonction de la valeur du paramètre de défocalisation D ou de mise au point du faisceau d'illumination.

On comprend bien sûr que le faisceau d'illumination en lumière blanche est focalisé à valeur constante par rapport à la surface de la résine de la plaquette témoin Pt, c'est-à-dire de l'interface air-résine, et, qu'en conséquence, en raison de la défocalisation du faisceau d'insolation des motifs de test de l'étape B, il en résulte, au cours du balayage de chaque motif de test, $MT_{ij}$ par le faisceau d'illumination, une défocalisation D correspondante. On comprend également que le faisceau d'illumination utilisé à l'étape 1000 peut au départ être réglé avec une focalisation relative, la meilleure possible compte tenu des moyens de mesure classique dont on dispose en laboratoire ou sur site industriel, ce qui permet bien entendu d'appliquer les valeurs de défocalisation correspondantes de chaque motif de test successif $MT_{ij}$ dans des conditions analogues de précision de réglage du faisceau d'insolation qui sera utilisé ultérieurement par la machine d'exposition pour réaliser des structures particulières, sur une ou plusieurs plaquettes substrat de circuit intégré. On comprend, bien entendu, que la détermination de la focalisation ou mise au point optimale du faisceau d'illumination vaut détermination de la focalisation ou mise au point optimale du faisceau d'insolation précité.

L'étape 3000 précédemment mentionnée est alors suivie d'une étape 4000 consistant à déterminer, par critère de seuil de la valeur du coefficient de réflectivié R, une plage de valeurs correspondantes de défocalisation ou mise au point pour le motif de test considéré permettant d'établir la valeur de mise au point optimale. Les étapes 3000 et 4000 précédemment mentionnées constituent l'étape IIb de traitement des données précédemment acquises en une étape IIa d'acquisition de ces données et elle comprend une étape de fin, notée 5000. L'ensemble des étapes 1000 à 4000 constitue en fait l'étape II de mise au point, conformément au procédé objet de la présente invention.

Une description plus détaillée des étapes IIa d'acquisition des données et IIb de traitement des données sera donnée en liaison avec la figure 1b.

Sur la figure précitée, l'étape 1000 d'illumination successive de chaque emplacement peut être subdivisée en sous-étapes 1001 de lecture d'un fichier représentant la position des motifs de test insolés sur la plaquette témoin, Pt, d'une sous-étape 1002 d'alignement sur des motifs de référence afin de déterminer la position précise de tous les motifs $MT_{ij}$. On notera que les motifs de référence peuvent être constitués par des motifs préférentiels, tels que par exemple, lorsque les motifs de test sont disposés en un réseau bidimensionnel rectangle, les motifs de test situés aux extrémités du rectangle délimitant ce réseau.

L'étape 1002 précitée est alors suivie d'une étape de positionnement du faisceau d'illumination sur le motif de test de rang k et en particulier sur le motif de test initial pour lequel, par convention, k = 1. On notera, ainsi qu'il sera décrit ultérieurement dans la description, que le positionnement du faisceau d'illumination est en fait réalisé au moyen d'une table X,Y et d'un microscope permettant d'assurer une visée sur le motif de test considéré, c'est-à-dire le motif de test de rang 1 précédemment mentionné. On comprend bien entendu que ce motif de test de rang 1 correspond à un motif de test $MT_{ij}$ d'adresse i,j donnée arbitraire, par exemple celle d'un motif de test de référence.

L'étape 1003 précédemment mentionnée est suivie d'une étape 1004 d'ajustement en mode manuel ou automatique de l'intensité lumineuse d'illumination à une valeur déterminée choisie. Cette étape 1004 comprend également par exemple la sous-étape d'éclairement constant du motif de test de rang k considéré. L'étape 1004 est alors suivie d'une sous-étape 2001 d'acquisition des valeurs de réflectivité du motif de test $MT_{ij}$ donné de rang k correspondant et d'une étape de sauvegarde des données du paramètre de réflectivité R correspondant, cette étape étant notée 2002, les étapes 2001 et 2002 formant, en fait, l'étape 2000 de mesure du coefficient de réflectivité R représenté en figure 1a. L'étape 2002 précitée est suivie d'une étape de test 2003 du rang k du motif de test considéré, ce test consistant en un test d'égalité du rang k à une valeur N représentative du nombre de motifs de test utilisé sur la plaquette et effectivement présents sur cette plaquette témoin Pt. Sur réponse négative au test 2003, la valeur du paramètre k de rang du motif de test soumis à acquisition des données est incrémentée d'une unité afin de passer à l'étape 1003, ainsi que symbolisé par la flèche de retour sur la figure 1b, afin de soumettre le motif de test suivant de rang k+1 aux mêmes sous-étapes 1003, 1004, 2001, 2002, 2003, que mentionné précédemment.

Sur réponse positive au test 2003, c'est-à-dire lorsque tous les motifs de test $MT_{ij}$ ont été soumis au processus IIa d'acquisition des données, le procédé objet de la présente invention consiste alors à mettre en oeuvre l'étape IIb de traitement des données.

Ainsi que représenté sur la figure 1b précitée, celle-ci peut comporter, à titre d'exemple non limitatif, une sous-étape 3001 de lecture des données, c'est-à-dire des valeurs de coefficient de réflectivité R pour chaque motif de test considéré, cette étape 3001 étant suivie d'une étape 3002 consistant à établir la loi de correspondance du coefficient de réflectivité R pour chaque emplacement, en fonction de la valeur du paramètre de défocalisation ou de mise au point du faisceau d'illumination. Cette étape consiste en fait à tracer la courbe de la réflectivité R en fonction de la défocalisation appliquée à chaque motif de test, lors de la création de ce dernier sur la plaquette témoin Pt, ainsi que déjà mentionné précédemment.

La sous-étape 3002 est alors suivie d'une sous-étape consistant à déterminer la valeur nominale de la focalisation ou mise au point optimale par une méthode à seuil, cette étape pouvant constituer l'étape 4000 précédemment mentionnée en relation avec la figure 1a.

L'affichage de la valeur de focalisation nominale ou de la mise au point optimale trouvée peut alors être affichée, par exemple sur un écran d'ordinateur.

Selon un aspect particulièrement avantageux du procédé objet de la présente invention, chaque motif de test $MT_{ij}$ est constitué par un réseau de trous, formé dans la couche de résine recouvrant la plaquette témoin Pt.

On notera en particulier que chaque motif de test est identique dans le plan X,Y de la surface de la résine, c'est-à-dire de l'interface air-résine, et qu'en conséquence, tant la dimension des trous, c'est-à-dire leur diamètre d que le pas du réseau, un réseau carré ou retangulaire, est identique. Toutefois, en raison de la défocalisation opérée au moment de l'insolation des motifs de test, c'est-à-dire lors de l'étape B de la figure la, les trous pour un motif de test $MT_{ij}$ considéré sont identiques, mais présentent des différences de profil, et en particulier de pente, d'un motif de test au suivant en fonction de la défocalisation appliquée, ainsi qu'il sera décrit ultérieurement dans la description.

Dans le cas précité, chaque motif de test étant constitué par un réseau de trous, et ainsi qu'on l'a représenté en figure 1c dans un diagramme représentant, en abcisses le paramètre de défocalisation D en micromètres, et en ordonnées le coefficient de réflectivité R mesuré pour chaque motif de test dans les conditions précédemment mentionnées, la mise au point optimale correspond à une plage de valeurs du coefficient de réflectivité R sensiblement stationnaire correspondant à la profondeur de champ de la machine d'exposition, ces valeurs étant encadrées par deux maxima correspondant à une défocalisation dans la résine, respectivement hors de la résine.

Sur la figure 1c, on comprend bien sûr que la plage de valeurs sensiblement stationnaires correspond à la référence 3, le maximum correspondant à une défocalisation dans la résine correspondant à la référence 2 alors que le maximum correspondant à une défocalisation hors de la résine correspond à la référence 4.

Conformément à un aspect particulièrement avantageux du procédé objet de la présente invention, la détermination précise de la mise au point optimale peut être effectuée de la façon ci-après : la plage de valeurs encadrant la valeur de mise au point optimale, cette mise au point optimale étant définie comme la défocalisation relative égale à 0, lorsque la focalisation du faisceau d'illumination, et par conséquent du faisceau d'insolation, correspond à une focalisation sur l'interface air-résine, cette plage de valeurs est obtenue par comparaison à une valeur de seuil. Cette plage de valeurs est alors validée comme plage de valeurs correspondante de mise au point optimale encadrant la valeur de mise au point optimale, ainsi que représenté sur la figure 1c. Cette valeur de seuil peut être égale à une fraction de la valeur minimale du coefficient de réflectivité, R, comprise entre les deux maxima précédemment mentionnés. On comprend alors que la valeur de seuil, notée VSS, est prise égale à :

VSS = βRmm, où Rmm représente la valeur minimum minimorum de la zone 3 située entre les deux maxima 2, 4 de la figure 1c, avec β < 1.

Ainsi, pour une valeur de seuil, VSS, déterminée, la loi de correspondance du coefficient de réflectivité R, en fonction de la valeur de défocalisation du faisceau d'illumination, permet-elle alors de définir deux valeurs d'abcisse correspondantes, δ- et δ+, intersection de la valeur de seuil avec la loi de correspondance précitée, et la valeur de défocalisation de mise au point optimale peut alors être définie pour la machine d'exposition comme l'abcisse de la moyenne arithmétique des valeurs d'extrémité de la plage de valeurs correspondantes de mise au point optimale, c'est-à-dire définie par les valeurs d'abcisse δ-,δ+ précédemment mentionnées, la valeur de mise au point optimale en défocalisation vérifiant alors la relation :

$$Do = 1/2 . (δ- + δ+).$$

Bien entendu, la valeur de défocalisation optimale peut alors être arbitrairement définie comme valeur zéro, puisqu'elle celle-ci exprime la valeur de défocalisation relative par rapport à l'interface air-résine.

On notera que le procédé objet de la présente invention tel que précédemment décrit permet d'obtenir une valeur stable du paramètre de défocalisation de mise au point optimale, en raison de la quasi-symétrie de la loi de correspondance du coefficient de réflectivité dans les zones de pente 2 et 5 de celle-ci, ces zones encadrant la plage de valeur de mise au point optimale.

D'une manière générale, on notera que, afin d'assurer une bonne précision de la mesure des valeurs du coefficient de réflectivité R, cette mesure, pour chaque motif de test, est de préférence réalisée en fond noir. Le fond noir permet d'être plus sensible à la défocalisation, car il permet la mise en relief de faibles variations de la pente de la résine, fonction elle-même de la défocalisation appliquée au moment de l'insolation.

Sur la figure 1c, on a également représenté pour les différentes zones caractéristiques de focalisation du faisceau d'illumination, d'une part, des vues en coupe des trous formant le réseau de la plaque témoin dans des vignettes correspondantes et, d'autre part, des vues de profil de sillons réalisés dans des conditions comparables. On notera en particulier que le profil le plus régulier des trous et corrélativement des sillons correspondant est obtenu lorsque la défocalisation correspond à la plage 3 de la courbe de réflectivité précitée et, en particulier, à la valeur de défocalisation de mise au point optimale. Dans ce cas, un trou est dit constituer un trou débouchant, dans la mesure où tous les trous formés avec la défocalisation correspondante du faisceau d'illumination et finalement du faisceau d'insolation, permet d'atteindre la surface du substrat avec une pente des parois latérales du trou supérieure à 85 degrés.

Un justificatif de la mise en oeuvre du procédé objet de la présente invention sera donné ci-après.

A la suite d'expérimentations successives, on a pu dégager l'ensemble des éléments ci-après : la loi de correspondance du coefficient de réflectivité R en fonction de la valeur du paramètre de défocalisation, tel que représenté en figure 1c, correspond sensiblement à la somme de deux enveloppes :

- une première enveloppe correspondant à la réflectivité due au substrat, cette première enveloppe présentant une courbe en cloche en fonction du paramètre de défocalisation D, et qui dépend à la fois de la taille des trous, c'est-à-dire du diamètre des trous, pour un réseau de trous donné, et de la nature du substrat,
- une deuxième enveloppe correspondant à la réflectivité due aux pentes des parois des trous formés dans la résine, cette réflectivité diminuant très fortement lorsqu'on est en zone extrême de défocalisation et présentant deux extrêma sensiblement symétriques séparés par une zone de faible réflectivité, cette zone de faible réflectivité correspondant bien sûr au maximum de la courbe en cloche de réflectivité du substrat, c'est-à-dire lorsque les trous formés pour constituer le motif de test par exemple sont des trous débouchants pour une pente des parois de résine maximale, le coefficient de réflectivité dû alors à la pente de la résine étant minimum, entre les deux maxima précités, l'ensemble des deux courbes de réflectivité, A et B, correspondant alors à la zone 3 de la figure 1c.

Ainsi, bien que la zone 3 de la figure 1c ne puisse être utilisée de manière efficace que pour déterminer une zone où les trous sont débouchants sur la surface du substrat, le fait que les flancs des maxima correspondants sont sensiblement égaux et symétriques permet, grâce à la méthode de seuil précédemment mentionnée, pour une machine d'exposition déterminée, une reproductibilité de la méthode proposée pour deux plaques différentes, dont la variation maximale de défocalisation optimale est de l'ordre de 0,2 micromètre.

Dans le même ordre d'idées, on notera que la défocalisation optimale mesurée sur une même plaque témoin, dix fois de suite conformément au procédé objet de la présente invention, permet de déterminer une variation maximale entre les différentes mesures n'excédant pas 0,1 micromètres.

Bien entendu, le traitement des valeurs ou données peut être plus sophistiqué, en particulier lorsqu'il apparaît des pics de réflectivité parasites sur les flancs des courbes correspondant aux zones 2 et 5 précitées. Ces pics parasites sont pour la plupart dûs à des problèmes inhérents à des défauts des plaquettes utilisées, tels que mauvaise qualité de la plaquette témoin, ou contamination de la face arrière entraînant une défocalisation locale importante. Dans ces conditions, il peut être approprié de procéder à un lissage des valeurs de la courbe sur plusieurs valeurs successives de réflectivité par exemple.

Enfin, on indiquera en ce qui concerne le procédé objet de la présente invention, que celui-ci est particulièrement avantageux dans la mesure où l'on a pu constater au cours d'essais que la mesure du coefficient de réflectivité R n'est pas sensible à une variation de la dose ou intensité d'énergie utilisée pour l'illumination des trous constituant les motifs de test $MT_{ij}$. Les essais précités ont ainsi montré que pour une énergie irradiée pour chaque illumination comprise entre 50 à 170 mJ (millijoules), la variation de défocalisation optimale pour un type de plaquette témoin déterminée n'excédait pas 0,1 micromètre.

En outre, on indiquera que le procédé objet de la présente invention, tel que décrit précédemment, peut être mis en oeuvre sur tout type de substrat, que ce soit un substrat silicium ou un substrat plus rugueux comme l'aluminium ou le tungstène ou même des substrats en silicium polycristallin, en nitrure de silicium, ou en oxyde de silicium.

Compte tenu des observations précitées, et en particulier des différences de réflectivité constatées pour les différentes valeurs de défocalisation, ainsi que représenté précédemment en figure 1c, le procédé objet de la présente invention permet également de contrôler l'inclinaison ou pente du flanc de gravure, à partir de la mise au point optimale ou position Do.

Dans ce but, le procédé selon l'invention consiste à effectuer un décalage de focalisation du faisceau d'insolation sur la plaquette substrat munie de la couche de résine, sur laquelle les structures doivent être engendrées. Bien entendu, le décalage de focalisation est réalisé dans une plage de valeurs incluses dans la plage de valeurs correspondant au minimum relatif compris entre les deux maxima de la loi de correspondance du coefficient de réflectivité et de la défocalisation. Ainsi, le décalage est réalisé pour les valeurs de défocalisation comprises dans la zone 3 de la figure 1c, par rapport à la valeur de focali-s-ation optimale Do.

Sur la figure 2a, on a représenté, en coupe, des échantillons photographiques de flancs de gravure de trous pour des valeurs de défocalisation comprises entre -2,4 micromètres, et 2,4 micromètres par incréments de 0,3 micromètres.

On constate ainsi que pour différentes inclinaisons ou pentes du profil de gravure, le décalage de défocalisation est réalisé, selon la direction du faisceau d'insolation, au-delà de l'interface air-résine pour la réalisation de flancs de gravure obliques concaves, c'est-à-dire en particulier pour les valeurs de défocalisation comprises entre -2,4 micromètres et -0,6 micromètres sensiblement. Le décalage de défocalisation est réalisé avec une valeur sensiblement nulle ou nulle pour la réalisation de flancs de gravure rectilignes sensiblement orthogonaux à l'interface résine-plaquette-substrat, les valeurs sensiblement nulles correspondant sur la figure 2a aux valeurs de décalage de focalisation comprises entre -0,6 micromètre et +0,6 micromètre sensiblement.

Le décalage de défocalisation est au contraire réalisé en-deçà de l'interface air-résine pour la réalisation de flancs de gravure dits à piédestal pour les valeurs de décalage de focalisation comprises entre 1,2 micromètres et 2,4 micromètres. On notera toutefois que la forme piédestal n'apparaît de manière significative que pour des valeurs de décalage supérieures à 1,8 micromètres.

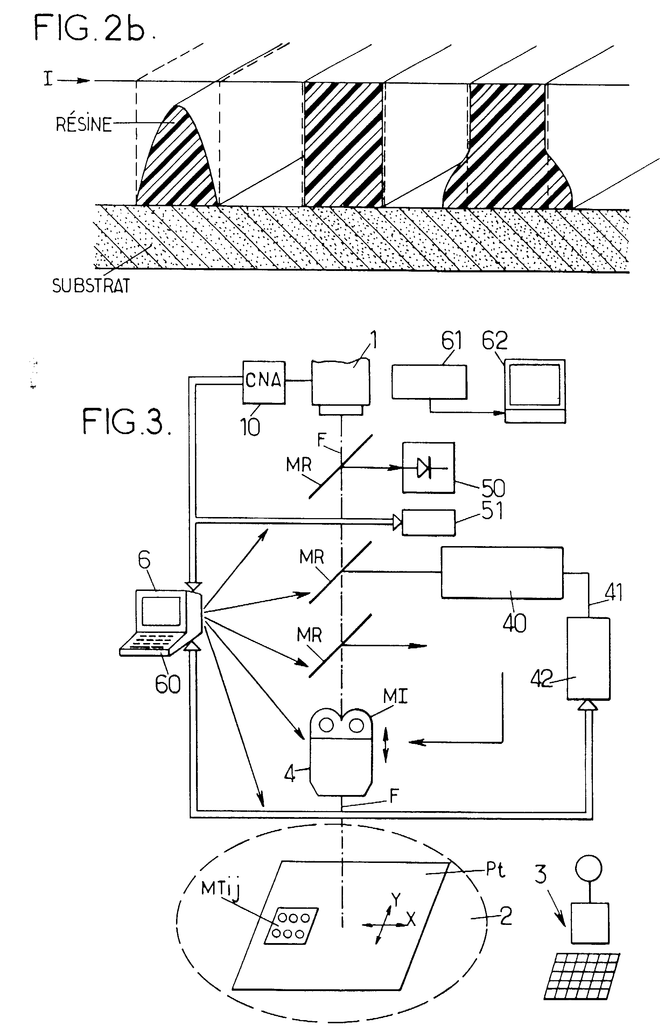

Sur la figure 2b, on a représenté, en coupe, des profils de gravure de sillons correspondant sensiblement aux trois zones précédemment mentionnées en relation avec la figure 2a.

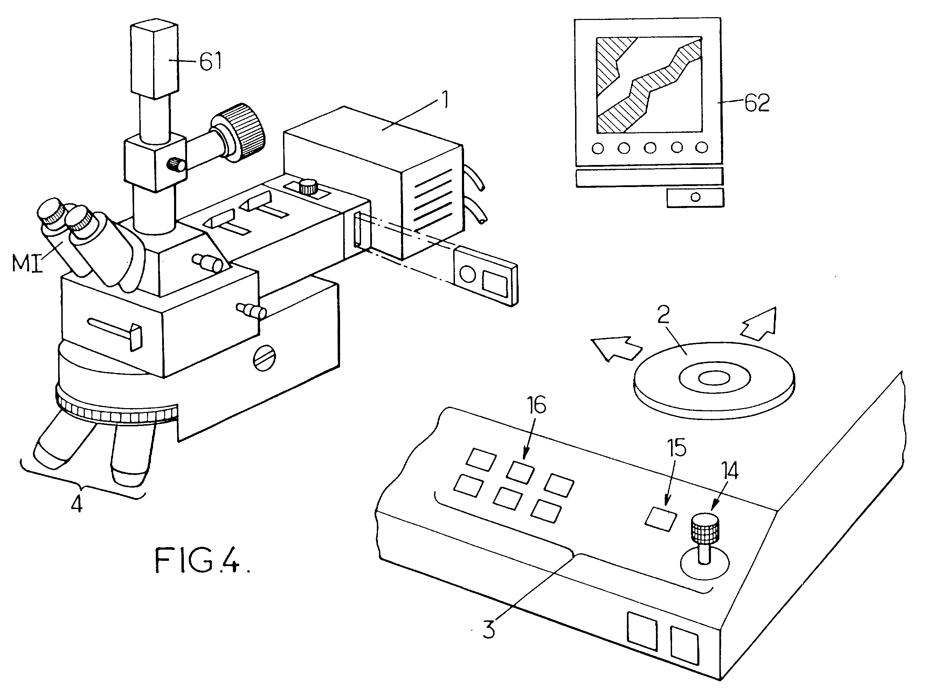

Une description plus détaillée du dispositif de réglage d'une machine d'exposition photolithographique objet de la présente invention sera maintenant donnée en liaison avec les figures 3 et 4.

Sur la figure 3, on peut constater que le dispositif selon l'invention comprend un bloc d'illumination au moyen d'un faisceau en lumière blanche d'une plaquette témoin Pt, la plaquette étant munie des motifs de test $MT_{ij}$ arrangés selon une suite de motifs de test. Un support 2 est prévu, celui-ci permettant de supporter la plaquette témoin Pt et d'assurer un positionnement de celle-ci selon un repère tridimensionnel x,y,z de cette plaquette par rapport au point de focalisation du faisceau de lumière blanche. On comprend bien sûr que le support 2 peut être constitué par une table x,y par exemple, le positionnement en z pouvant être effectué par la focalisation du faisceau et la défocalisation de celui-ci.

En outre, un circuit 3 de commande du positionnement de la plaquette témoin Pt est prévu de façon à assurer un balayage séquentiel de la suite de motifs de test de la plaque témoin précitée, et une défocalisation relative différente pour chaque motif de test de la suite de motifs de test imprimés sur la plaque témoin par rapport à l'interface air-résine.

Un élément 4 collecteur du faisceau lumineux diffusé par le motif de test corresondant, $MT_{ij}$, et par la surface de la plaquette témoin illuminée par le faisceau de lumière blanche est prévu. Celui-ci peut être réalisé par un objectif optique comportant, notamment, un binoculaire d'observation, l'ensemble formant un microscope permettant une observation visuelle.

En outre, un circuit 5 de mesure et de mémorisation du coefficient de réflectivité est prévu, ce coefficient étant défini par le rapport de l'intensité du faisceau diffusé à l'intensité du faisceau d'illumination en lumière blanche. Ce circuit 5 peut comporter, avantageusement, une photodiode de réception du faisceau diffusé, notée 50, et un convertisseur analogique-numérique 51, par exemple. En outre, le dispositif comprend différents miroirs de renvoi, notés MR, formés par exemple par des miroirs semi-transparents, permettant d'une part la transmission du faisceau d'illumination F en lumière blanche vers la plaquette témoin Pt, et d'autre part, la retransmission du faisceau lumineux diffusé collecté par l'élément collecteur 4, d'une part vers la photodiode 50 précitée, ou vers d'autres circuits, lesquels seront décrits plus en détails ci-après.

Enfin, un dispositif 6 de calcul et d'affichage de la loi de correspondance du coefficient de réflectivité et de la défocalisation relative du faisceau d'illumination et de la plaquette témoin est prévu, ce dispositif de calcul et d'affichage permettant également d'afficher la mise au point optimale et un décalage de focalisation à cette mise au point optimale, afin, le cas échéant, d'obtenir les effets de pente précédemment décrits dans la description.

En outre, selon un aspect avantageux du dispositif objet de la présente invention, l'élément d'illumination 1 comporte une boucle d'asservissement de l'intensité du faisceau d'illumination F pour l'obtention d'une intensité du faisceau diffusé par chaque motif de test et par la surface de la plaquette témoin Pt sensiblement constante. De manière avantageuse, la boucle d'asser-vissement précitée peut être constituée à partir d'un miroir de renvoi MR renvoyant une fraction du faisceau lumineux diffusé, d'un circuit récepteur 40 directement relié par exemple par une liaison par fibre optique 41 et par un convertisseur analogique-numérique 42 au dispositif de calcul 6. Le dispositif de calcul 6 peut également être relié à l'élément 1 d'illumination par une liaison par BUS et par l'intermédiaire d'un convertisseur numérique-analogique 10 permettant d'assurer ainsi la boucle d'asservissement précitée. Le dispositif objet de l'invention permet ainsi de travailler avec une intensité diffusée constante, laquelle peut être choisie de façon à correspondre au maximum de sensibilité de la photodiode de réception 50.

Selon un aspect particulièrement avantageux du dispositif objet de la présente invention, l'élément 1 d'illumination et l'élément collecteur 4 du faisceau diffusé peuvent être constitués par un objectif d'illumination en fond noir.

Dans un mode de réalisation pratique, l'élément collecteur 4 du faisceau lumineux diffusé était réalisé au moyen d'un microscope MS 09 commercialisé en France par la société NACHET. Ce microscope est un microscope modulaire pouvant recevoir de nombreux accessoires, rendant de ce fait l'utilisation de ce dernier très souple dans de nombreux domaines. Ainsi, la tourelle du microscope utilisée peut recevoir 5 objectifs de type Union fond noir.

Ce microscope est en outre équipé d'un système d'autofocalisation dynamique à diode infrarouge, système permettant de garantir la conservation de la mise au point lors du déplacement de l'objet.

En outre, le microscope précité permet un passage d'un éclairage fond clair/fond noir, commandé par un sélecteur manuel, en face avant du microscope.

En mode fond clair, un diaphgragme de champ et un diaphragme d'ouverture permettent d'optimiser la qualité de l'éclairage. Sur la figure 4, on a représenté un détail du microscope et de l'ensemble comportant l'élément d'illumination 1 ainsi que l'élément collecteur 4. L'élément d'illumination est alimenté par une ampoule halogène 12 volts 50 watts, montée sur un support centrable. Enfin, la fibre optique de prélèvement d'intensité du faisceau diffusé fournit un signal d'asservissement du signal d'éclairage par l'intermédiaire du dispositif de calcul 6.

Le microscope précité est équipé d'un binoculaire d'observation permettant de sélectionner l'observation visuelle binoculaire ou l'observation vidéo et la mesure en sortie auxiliaire. Le commutateur d'observation est constitué par une tirette située sur le corps du binoculaire. Le binoculaire précité peut recevoir des oculaires d'observation, 10 X, dont l'un est équipé d'un réticule afin d'effectuer un alignement visuel. On notera cependant que le mode de réalisation présentement décrit n'est pas limitatif, et qu'en particulier, une caméra vidéo, ainsi que représenté en figure 4, portant la référence 61, peut être placée dans le champ de l'objectif 4 du microscope. La caméra vidéo 61 peut avoir pour fonction soit, grâce à un programme logiciel de reconnaissance de forme, d'effectuer un centrage automatique par visée et reconnaissance de forme sur chaque motif de test considéré, soit également de permettre un affichage du motif de test visé par l'intermédiaire d'un moniteur, 62, à grande résolution. La caméra vidéo 61 peut être constituée par une caméra standard de type CCD noir et blanc par exemple.

La voie vidéo est munie d'une monture pour la caméra 61 précitée, alors que la voie mesure est munie d'une interface photo, et d'un oculaire de projection photographique de type 10 X M. La cellule photodiode 50 collecte le flux délivré par l'oculaire de projection photo dans la pupille de sortie sur un champ limité par un diaphragme, diaphragme de 1 mm en standard, diaphragme de 4 mm en option. Les signaux de mesure sont directement transmis au dispositif de calcul 6 par l'intermédiaire d'un convertisseur analogique-numérique 51 précédemment mentionné. Le convertisseur utilisé était un convertisseur de 0 à 10 volts sur 1096 points.

En ce qui concerne le support 2 de la plaquette témoin 2, constitué par une table mobile XY, celui-ci peut être constitué par une table à grand déplacement équipée d'un support de plaquette de circuit intégré, notée 20, avec aspiration par vide. Bien entendu, le support et la table à grand déplacement supportent le microscope et l'ensemble représenté en figure 4. La table est pilotée par l'intermédiaire d'une liaison de type RS 232 par l'intermédiaire du dispositif de calcul 6. On notera que le circuit 3 de commande du positionnement de la plaquette témoin comporte, d'une part, une manette de commande, notée 14, permettant le déplacement de la table en X et en Y, ainsi que des touches de commande, notées 16, dont l'une, notée IEE, permet le pilotage de la table mobile par la liaison RS 232.

En ce qui concerne le dispositif de calcul 6, on notera que celui-ci comprend avantageusement un calculateur 60 muni de ses ressources périphériques telles que mémoire de programme, mémoire morte et mémoire d'affichage, ce calculateur 60 pouvant être constitué par un micro-ordinateur de type PC AT ou compatible.

On notera que ce calculateur est muni de programmes de conduite du processus de détermination de la mise au point optimale et du décalage de cette mise au point optimale, selon un dialogue interactif avec un opérateur.

On comprend ainsi que l'ensemble des étapes du procédé objet de la présente invention tel que défini en liaison avec les figures 1a, partie II mise au point, et 1b, sont conduites par l'intermédiaire d'un logiciel de conduite du procédé. Ainsi, en particulier, les étapes 1001, 1002, 1003, 1004, 2001, 2002, 2003, 3001, 3002 et 4000 représentées en figure 1b correspondent à des programmes et sous-programmes de conduite du procédé correspondant.

En ce qui concerne l'étape 1003 de la figure 1b, dans laquelle un positionnement de la table mobile 2 du microscope sur le motif de rang k est réalisé, ou à tout le moins en ce qui concerne l'alignement sur les motifs de référence afin de déterminer la position précise de tous les motifs à l'étape 1002 précédente, le logiciel correspondant demande pour l'exécution de cette étape 1002 un alignement visuel ou éventuellement un alignement effectué par l'intermédiaire d'une caméra et d'un logiciel de reconnaissance de forme. Dans un tel cas, l'opérateur prend la conduite du procédé en main par l'intermédiaire de la manette 14 ou levier de commande, lequel permet de déplacer la table mobile sous le microscope en X ou en Y. La vitesse de déplacement peut alors être modifiée en tournant le levier autour de son axe. Le levier 14 peut être muni d'un bouton permettant d'obtenir la fonction suivante, lorsque ce bouton est maintenu pressé:

- en index → index,
- en pas à pas → pas rapide,
- en vitesse lente → vitesse moyenne,
- en vitesse rapide → vitesse rapide.

Lorsque l'alignement est effectué, la touche 15 de la table mobile permet de relancer la conduite du processus en mode automatique, le balayage des différents motifs $MT_{ij}$ de la plaquette témoin Pt étant effectué automatiquement par déplacement du support 2 de la table mobile, selon une loi séquentielle déterminée. Bien entendu, la défocalisation en fonction de la position du motif de test considéré est également effectuée de manière automatique.

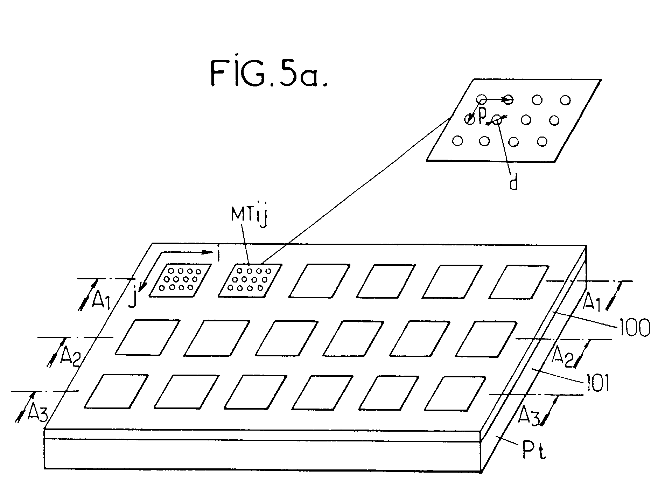

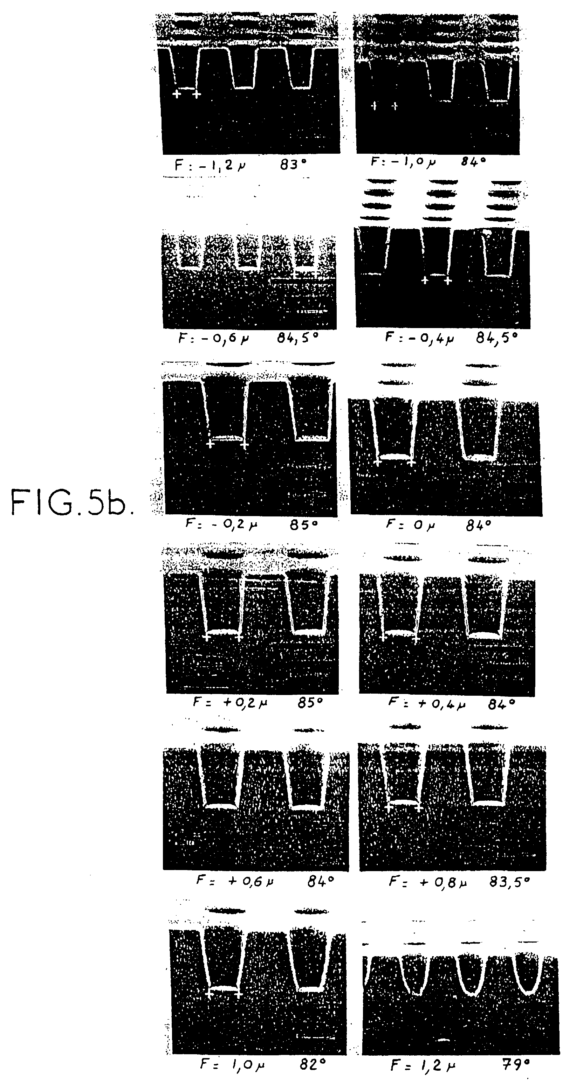

Une description plus détaillée d'une plaquette témoin Pt sera donnée en liaison avec les figures 5a et 5b.

Selon la figure 5a, chaque plaquette témoin Pt est formée par un substrat, tel qu'un substrat silicium par exemple, portant la référence 101, et une couche de résine 100 dans laquelle est formée une pluralité de motifs de test $MT_{ij}$ identiques et arrangés en une suite de motifs de test. Par motifs de test identiques, on indique que la dimension en i,j de chaque motif de test est identique, alors que la plaquette varie d'un motif de test à l'autre.

Selon une caractéristique avantageuse de la plaquette témoin objet de la présente invention, les motifs de test sont formés par un réseau de trous de pas p et de dimension d déterminés par rapport à l'état de surface ou rugosité moyenne r du substrat formant la plaquette témoin, selon la relation :

$$d \leq \alpha r$$

$$p \geq 2d.$$

On notera que dans les relations précitées, d représente le diamètre de trous formant le réseau, p formant le pas du réseau précité. Le paramètre a peut être compris entre les valeurs 2 et 5 par exemple.

Sur la figure 5b, on a représenté une vue en coupe selon les plans de coupe $A_1 A_1$, $A_2 A_2$, $A_3 A_3$ de la figure 5a, d'une suite de motifs de tests considérée, chaque motif de test $MT_{ij}$ correspondant en fait à une valeur de défocalisation différente. On constate sur les vues en coupe précitées que les profils des trous formant le réseau de chaque motif de test sont donc différents, la pente des trous du réseau étant sensiblement symétrique par rapport à la valeur de défocalisation 0 correspondant à la valeur Do précédemment mentionnée sur la figure 1c.

En ce qui concerne la dimension des trous formant le réseau précité, on notera que celle-ci doit être proche de la limite de résolution de la machine d'exposition photolithographique dont le réglage doit être effectué par la mise en oeuvre du procédé objet de la présente invention. En outre, la dose d'illumination utilisée, c'est-à-dire l'intensité lumineuse d'illumination de chaque motif de test $MT_{ij}$, doit être également minimale, afin d'obtenir pour les fortes valeurs de défocalisation des trous pratiquement complètement bouchés. Confer figure 1c, zones 5 et 6. On indiquera en outre que le pas p du réseau n'est pas un paramètre critique, car il influe essentiellement sur le niveau de réflectivité du réseau.

Les essais précédemment mentionnés ont été réalisés avec un trou de 0,6 micromètres et un pas de 2,4 micromètres, sur un photorépéteur d'ouverture numérique 0,40. Enfin, la dimension de chaque réseau constituant un motif de test $MT_{ij}$ considéré est au minimum de 50 x 50 micromètres carrés.

On a ainsi décrit un procédé de réglage d'une machine d'exposition photolithographique et un dispositif permettant la mise en oeuvre de celui-ci particulièrement performants, car ils permettent le contrôle de la stabilité de la focalisation de ces machines d'exposition avec, vis-à-vis des procédés ou des dispositifs de l'art antérieur, les avantages ci-après : excellente reproductibilité d'une mise en oeuvre du procédé, insensibilité au changement de réticule ou au niveau d'éclairement dans les limites précédemment indiquées dans la description, facilité du motif du réseau à réaliser, indépendance de la valeur de focalisation nominale vis-à-vis de l'opérateur conduisant les mesures et rapidité de l'exposition comme de la lecture des résultats.

## Revendications

1. Procédé de détermination de la mise au point d'une machine d'exposition photolithographique utilisée pour insoler des structures sur une plaquette substrat revêtue d'une résine formant masque, à partir d'une plaquette témoin munie de motifs de test identiques en différents emplacements arrangés selon une suite de motifs de test, caractérisé en ce qu'il consiste :

- à illuminer successivement lesdits motifs de test en lumière blanche au niveau de chaque emplacement, au moyen d'un faisceau d'illumination,
- à mesurer le coefficient de réflectivité de chaque motif de test, et
- à établir la loi de correspondance dudit coefficient de réflectivité en fonction, pour chaque emplacement, de la valeur du paramètre de défocalisation ou de mise au point du faisceau d'illumination,
- à déterminer, par critère de seuil de la valeur dudit coefficient de réflectivité, une plage de valeurs correspondantes de défocalisation ou mise au point pour le motif de test considéré, permettant d'établir la valeur de mise au point optimale.

2. Procédé selon la revendication 1, caractérisé en ce que, pour un motif de test constitué par un réseau de trous, ladite mise au point optimale correspond à une plage de valeurs sensiblement stationnaires du coefficient de réflectivité, correspondant à la profondeur de champ de la machine d'exposition, encadrées par deux maxima correspondant à une défocalisation dans la résine respectivement hors de la résine.

3. Procédé selon la revendication 1 ou 2, caractérisé en ce que ladite plage de valeurs est obtenue par comparaison à une valeur de seuil, ladite plage étant validée comme plage de valeurs correspondantes de mise au point optimale, ladite valeur de seuil étant égale à une fraction de la valeur minimale du coefficient de réflectivité comprise entre les deux maxima.

4. Procédé selon l'une des revendications 1 à 3, caractérisé en ce que ladite mesure du coefficient de réflectivité de chaque motif est réalisée en fond noir, ce qui permet d'augmenter la sensibilité de la mesure de la défocalisation et une amélioration de la mise au point.

5. Procédé selon l'une des revendications précédentes, caractérisé en ce que la mise au point optimale de ladite machine d'exposition est définie comme l'abscisse de la moyenne arithmétique des valeurs d'extrémité de ladite plage de valeurs correspondantes de mise au point optimale.

6. Procédé selon la revendication 5, caractérisé en ce que, afin de contrôler l'inclinaison ou pente du flanc de gravure, celui-ci consiste, à partir de ladite mise au point optimale, à effectuer un décalage de focalisation dudit faisceau d'insolation, ledit décalage étant réalisé dans une plage de valeurs incluses dans la plage de valeurs correspondant au minimum relatif compris entre les deux maxima de la loi de correspondance du coefficient de réflectivité et de la défocalisation.

7. Procédé selon la revendication 6, caractérisé en ce que, pour différentes inclinaisons ou pentes du profil de gravure, ledit décalage de défocalisation est réalisé, selon la direction du faisceau d'insolation,

- au-delà de l'interface air-résine pour la réalisation de flancs de gravure obliques concaves,
- avec une valeur nulle pour la réalisation de flancs de gravure rectilignes sensiblement orthogonaux à l'interface air-résine,
- en deça de l'interface air-résine pour la réalisation de flancs de gravure à piédestal.

8. Dispositif de réglage de la mise au point d'une machine d'exposition photolithographique utilisée pour exposer des structures sur une plaquette substrat revêtue d'une résine formant masque, à partir d'une plaquette témoin munie de motifs de test identiques en différents emplacements arrangés selon une suite de motifs de test, caractérisé en ce qu'il comporte :

- des moyens d'illumination, au moyen d'un faisceau en lumière blanche, d'une plaquette témoin, munie de motifs de test, arrangés selon une suite de motifs de test,
- des moyens support de ladite plaquette témoin permettant d'assurer un positionnement selon un repère tri-dimensionnel (x, y, z) de ladite plaquette témoin par rapport au point de focalisation dudit faisceau de lumière blanche,
- des moyens de commande du positionnement de ladite plaquette témoin de façon à assurer un balayage séquentiel de la suite de motifs de test et une défocalisation relative différente pour chaque motif de test de la suite de motifs de test par rapport à l'interface résine-plaquette témoin,
- des moyens collecteurs du faisceau lumineux diffusé par le motif de test correspondant et par la surface de la plaquette témoin illuminée par ledit faisceau de lumière blanche,
- des moyens de mesure et de mémorisation du coefficient de réflectivité, rapport de l'intensité du faisceau diffusé à l'intensité du faisceau d'illumination,
- des moyens de calcul et d'affichage de la loi de correspondance dudit coefficient de réflectivité et de la défocalisation relative du faisceau d'illumination et de la plaquette témoin, de la mise au point optimale et d'un décalage de focalisation à cette mise au point optimale.

9. Dispositif selon la revendication 8, caractérisé en ce que lesdits moyens d'illumination comportent une boucle d'asservissement de l'intensité dudit faisceau d'illumination pour l'obtention d'une intensité du faisceau diffusé par chaque motif de test et par la surface de ladite plaquette témoin sensiblement constante.

10. Dispositif selon la revendication 8 ou 9, caractérisé en ce que lesdits moyens d'illumination et lesdits moyens collecteurs du faisceau diffusé sont constitués par un objectif d'illumination en fond noir.

11. Dispositif selon la revendication 8, caractérisé en ce que lesdits moyens de calcul et d'affichage comprennent :

- un calculateur muni de ses ressources périphériques telles que mémoire de programme, mémoire morte et moniteur d'affichage,
- des programmes de conduite du processus de détermination de la mise au point optimale et d'un décalage de cette mise au moint optimale, selon un dialogue interactif avec un opérateur.

12. Plaquette témoin pour la mise en oeuvre du procédé selon l'une des revendications 1 à 7, caractérisée en ce que celle-ci comporte une pluralité de motifs de test identiques arrangés en une suite de motifs de test, ces motifs de test étant ménagés dans une couche de résine déposée sur une plaquette substrat, lesdits motifs de test étant formés par un réseau de trous de pas p et de dimension d déterminés par rapport à l'état de la surface ou rugosité moyenne r du substrat formant la plaquette témoin selon la relation :

$$d \leq \alpha r$$

$\alpha$ étant compris entre 2 et 5,

$$p \geq 2d.$$

**Patentansprüche**

1. Verfahren zur Bestimmung der Scharfeinstellung einer photolithographischen Belichtungsvorrichtung, die benutzt wird, um Strukturen auf einer mit einem eine Blende bildenden Kunstharz beschichteten Trägerplatte zu belichten, ausgehend von einer Vergleichsplatte, die an verschiedenen, entsprechend einer Testmotivfolge angeordneten Positionen mit identischen Testmotiven versehen ist, dadurch gekennzeichnet, daß das Verfahren darin besteht,

- die Testmotive nacheinander auf gleicher Ebene mit jeder Position mittels eines Belichtungsstrahlenbündels mit Weißlicht zu belichten,
- den Reflektivitätskoeffizienten jedes Testmotivs zu messen und
- das Zuordnungsgesetz des Reflektivitätskoeffizienten für jede Position in Abhängigkeit von dem Wert des Defokussierungs- oder Scharfeinstellungsparameters des Belichtungsstrahlenbündels festzustellen.
- über ein Schwellenkriterium des Werts des Reflektivitätskoeffizienten einen Bereich von entsprechenden Defokussierungs- oder Scharfeinstellungswerten für das betrachtete Testmotiv zu bestimmen, der es gestattet, den optimalen Scharfeinstellungswert festzulegen.

2. Verfahren nach Anspruch 1, dadurch gekennzeichnet, daß für ein aus einem Raster von Löchern bestehenden Testrnotiv die optimale Scharfeinstellung einem Bereich im wesentlichen feststehender Werte des Reflektivitätskoeffizienten entspricht, die entsprechend dem Schärfenbereich der Belichtungsvorrichtung von zwei Maxima umrahmt werden, welche einer Defokussierung in dem Kunstharz beziehungsweise außerhalb des Kunstharzes entsprechen.

3. Verfahren nach Anspruch 1 oder 2, dadurch gekennzeichnet, daß der Wertebereich durch Vergleich mit einem Schwellenwert erhalten wird, wobei der Bereich als Bereich entsprechender Werte optimaler Scharfeinstellung gilt, wobei der Schwellenwert gleich einem Bruchteil des zwischen den beiden Maxima liegenden Minimums des Reflektivitätskoeffizienten ist.

4. Verfahren nach einem der Ansprüche 1 bis 3, dadurch gekennzeichnet, daß die Messung des Reflektivitätskoeffizienten jedes Motivs im Dunkelfeld durchgeführt wird, wodurch die Genauigkeit der Defokussierungsmessung erhöht wird und eine Verbesserung der Scharfeinstellung möglich ist.

5. Verfahren nach einem der vorhergehenden Ansprüche, dadurch gekennzeichnet, daß die optimale Scharfeinstellung der Belichtungsvorrichtung als Abszisse des arithmetischen Mittels der Extrema des Bereichs entsprechender Werte optimaler Scharfeinstellung definiert ist.

6. Verfahren nach Anspruch 5, dadurch gekennzeichnet, daß zur Überprüfung der Neigung oder Abschrägung der Gravurflanke das Verfahren darin besteht, ausgehend von der optimalen Scharfeinstellung eine Verschiebung der Fokussierung des Belichtungsstrahlenbündels vorzunehmen, wobei die Verschiebung in einem Bereich von Werten stattfindet, die in dem Wertebereich liegen, der dem relativen Minimum zwischen den beiden Maxima des Zuordnunggesetzes des Reflektivitätskoeffizienten und der Defokussierung entspricht.

7. Verfahren nach Anspruch 6, dadurch gekennzeichnet, daß für verschiedene Neigungen oder Abschrägungen des Gravurprofils die Defokussierungsverschiebung entsprechend der Richtung des Belichtungsstrahlenbündels

- zur Realisierung von schrägen, konkaven Gravurflanken jenseits der Luft-Kunstharz-Grenzfläche,
- zur Realisierung von geradlinigen, zur Luft-Kunstharz-Grenzfläche im wesentlichen senkrechten Gravurflanken mit einem Wert Null,
- zur Realisierung von Gravurflanken mit Sockel diesseits der Luft-Kunstharz-Grenzfläche stattfindet.

8. Vorrichtung zur Regelung der Scharfeinstellung einer photolithographischen Belichtungvorrichtung, die benutzt wird, um Strukturen auf einer mit einem eine Blende bildenden Kunstharz beschichteten Trägerplatte zu belichten, ausgehend von einer Vergleichsplatte, die an verschiedenen, entsprechend einer Testmotivfolge angeordneten Positionen mit identischen Testmotiven versehen ist, dadurch gekennzeichnet, daß die Vorrichtung umfaßt:

- Mittel zur Belichtung einer mit entsprechend einer Testmotivfolge angeordneten Testmotiven versehenen Vergleichsplatte mittels eines Weißlichtstrahlenbündels,
- Mittel zum Tragen der Vergleichsplatte, die es ermöglichen, eine Positionierung der Vergleichsplatte relativ zurn Fokussierpunkt des Weißlichtstrahlenbündels entsprechend eines dreidimensionalen Bezugspunktes (x, y, z) sicherzustellen,
- Mittel zum Steuern der Positionierung der Vergleichsplatte, so daß eine sequentielle Bestreichung der Testmotivfolge und eine für jedes Testmotiv der Testmotivfolge unterschiedliche relative Defokussierung gegenüber der Kunstharz-Vergleichsplatte-Grenzfläche gewährleistet ist,
- Mittel zum Sammeln des Strahlenbündels, das durch das entsprechende Testmotiv und die Oberfläche der von dem Weißlichtstrahlenbündel belichteten Vergleichsplatte gestreut wird,
- Mittel zum Messen und Speichern des Reflektivitätskoeffizienten als Ausdruck des Verhältnisses der Intensität des gestreuten Strahlenbündels zu der Intensität des Belichtungsstrahlenbündels,
- Mittel zur Berechnung und Anzeige des Zuordnungsgesetzes des Reflektivitätskoeffizienten und der relativen Defokussierung des Belichtungsstrahlenbündels und der Vergleichsplatte, der optimalen Scharfeinstellung und einer Verschiebung der Fokussierung zu dieser optimalen Scharfeinstellung.

9. Vorrichtung nach Anspruch 8, dadurch gekennzeichnet, daß zum Erhalt einer im wesentlichen konstanten Intensität des von jedem Testmotiv und der Oberfläche der Vergleichsplatte gestreuten Strahlenbündels die Mittel zur Belichtung einen Intensitäts-Regelkreis für das Belichtungsstrahlenbündel umfassen.

10. Vorrichtung nach Anspruch 8 oder 9, dadurch gekennzeichnet, daß die Mittel zur Belichtung und die Mittel zum Sammeln des gestreuten Strahlenbündels von einem Dunkelfeld-Belichtungsobjektiv gebildet werden.

11. Vorrichtung nach Anspruch 8, dadurch gekennzeichnet, daß die Mittel zur Berechnung und zur Anzeige umfassen:

    - einen Rechner, der mit Peripheriegeräten wie Programmspeicher, Festspeicher und Anzeigemonitor ausgestattet ist,
    - Programme zur Durchführung des Verfah.rens zur Bestimmung der optimalen Scharfeinstellung und einer Verschiebung dieser optimalen Scharfeinstellung entsprechend einem interaktiven Dialog mit einer Bedienungsperson.

12. Vergleichsplatte zur Durchführung des Verfahrens nach einem der Ansprüche 1 bis 7, dadurch gekennzeichnet, daß sie eine Vielzahl von identischen Testmotiven aufweist, die in einer Testmotivfolge angeordnet sind, wobei diese Testmotive in einer auf eine Trägerplatte aufgebrachten Kunstharzschicht ausgespart sind, wobei die Testmotive von einem Raster von Löchern mit der Teilung p und der Abmessung d gebildet werden, die bezogen auf die Oberflächenbeschaffenheit oder die mittlere Rauheit r des die Vergleichsplatte bildenden Trägers entsprechend der Relation

$$d \leq \alpha r$$

wobei $\alpha$ zwischen 2 und 5 liegt,

$$p \geq 2d$$

bestimmt werden.

## Claims

1. A process for determining the sharp focus of a photolithographic exposure machine used to insolate structures on a substrate wafer coated with a mask-forming resin, starting from a guide wafer furnished with identical test patterns at various locations arranged as a series of test patterns, said process consisting:

    - in successively illuminating the said test patterns with white light in the vicinity of each location, by means of an illuminating beam,
    - in measuring the coefficient of reflectivity of each test pattern, and
    - in establishing the law of correspondence of the said coefficient of reflectivity as a function, for each location, of the value of the defocusing or sharp focus parameter of the illuminating beam,
    - in determining, by criterion of threshold of the value of the said coefficient of reflectivity, a range of corresponding values of defocusing or sharp focus for the relevant test pattern, enabling the optimum sharp focus value to be established.

2. A process according to Claim 1, characterized by for a test pattern consisting of a network of holes, the said optimum sharp focus corresponding to a range of substantially stationary values of the coefficient of reflectivity, corresponding to the depth of field of the exposure machine, flanked by two maxima corresponding to a defocusing in the resin and outside the resin respectively.

3. A process according to Claim 1 or 2, characterized by said range of values being obtained by comparison with a threshold value, the said range being confirmed as range of corresponding values of optimum sharp focus, the said threshold value being equal to a fraction of the minimum value of the coefficient of reflectivity lying between the two maxima.

4. A process according one of Claims 1 to 3, characterized by the said measurement of the coefficient of reflectivity of each pattern being carried out with a black background, this making it possible to increase the sensitivity of the measurement of the defocusing and allowing an improvement in the sharp focus.

5. A process according to one of preceding Claims, characterized by the optimum sharp focus of the said exposure machine being defined as the abscissa of the arithmetic mean of the end values of the said range of corresponding values of optimum sharp focus.

6. A process according to Claim 5, characterized by, in order to check the inclination or slope of the gravure flank, said process consisting starting from the said optimum sharp focus, in performing a focusing shift of the said insolating beam, the said shift being carried out within a range of values included within the range of values corresponding to the relative minimum lying between the two maxima of the law of correspondence of the coefficient of reflectivity and of the defocusing.

7. A process according to Claim 6, characterized by, for various inclinations or slopes of the gravure profile, the said defocusing shift being carried out, in the direction of the insolating beam,

   - to the far side of the air/resin interface for the production of concave, oblique gravure flanks,
   - with a zero value for the production of straight gravure flanks substantially orthogonal to the air/resin interface,
   - on the near side of the air/resin interface for the production of pedestal gravure flanks.

8. Device for adjusting the sharp focus of a photolithographic exposure machine used to expose structures on a substrate wafer coated with a mask-forming resin, starting from a guide wafer furnished with identical test patterns at various locations arranged as a series of test patterns, said device including:

   - means of illumination, by means of a beam of white light, of a guide wafer, furnished with test patterns, arranged in a series of test patterns,
   - support means for the said guide wafer making it possible to afford a positionning in a three-dimensional reference frame (x, y, z) of the said guide wafer with respect to the focusing point of the said white light beam,
   - means for controlling the positionning of the said guide wafer so as to afford a sequential scanning of the series of test patterns and a different relative defocusing for each test pattern of the series of test patterns with respect to the resin/guide wafer interface,
   - collector means for the light beam diffused by the corresponding test pattern and by the surface of the guide wafer illuminated by the said white light beam,
   - means of measuring and storing the coefficient of reflectivity, ratio of the intensity of the diffused beam to the intensity of the illuminating beam,
   - means of computation and of display of the law of correspondence of the said coefficient of reflectivity and of the relative defocusing of the illuminating beam and of the guide wafer, of the optimum sharp focus and of a focusing shift at this optimum sharp focus.

9. Device according to Claim 8, characterized by said illuminating means including a loop for servo control of the intensity of the said illuminating beam in order to obtain an intensity of the beam diffused by each test pattern and by the surface of the said substantially constant guide wafer.

10. Device according to Claim 8 or 9, characterized by said means of illumination and the said collector means for the diffused beam consisting of an objective for illumination with black background.

11. Device according to Claim 8, characterized by said means of computation and of display comprising:

   - a calculator furnished with its peripheral resources such as program memory, read-only memory and display monitor,
   - programs for running the procedure for determination of the optimum sharp focus and for a shift of this optimum sharp focus, by interactive dialogue with an operator.

12. Guide wafer for carrying out the method according to one of the claims 1 to 7, characterized by, including a plurality of identical test patterns arranged in a series of test patterns, these test patterns being made in a resin layer deposited on a substrate wafer, said test patterns being formed by a network of holes of spacing p and of dimension d which are determined with respect to the surface condition or mean roughness r of the substrate forming the guide wafer according to the relation:

$$d \leq \alpha r$$

$\alpha$ lying between 2 and 5,

$$p \geq 2d.$$

FIG.1a.

A — DÉPÔT RÉSINE SUR PLAQUETTE SILICIUM

B — INSOLATION MOTIFS DE TEST EN DIFFÉRENTS EMPLACEMENTS/ FOCALISATION D

C — DÉVELOPPEMENT

MTij

I RÉALISATION D'UNE PLAQUETTE TÉMOIN

IIa) ACQUISITION DES DONNÉES

1000 ILLUMINATION SUCCESSIVE DE CHAQUE EMPLACEMENT

2000 MESURE COEFFICIENT DE RÉFLECTIVITÉ R

3000 ÉTABLISSEMENT LOI RÉFLECTIVITÉ FOCALISATION D

II MISE AU POINT

IIb) TRAITEMENT DES DONNÉES

4000 ÉTABLISSEMENT MISE AU POINT OPTIMALE PAR CRITÈRE DE SEUIL

5000 FIN

# FIG.1b.

LECTURE D'UN FICHIER REPRÉSENTANT LA POSITION DES MOTIFS INSOLÉS SUR LA PLAQUETTE TÉMOIN — 1001

↓

ALIGNEMENT SUR LES MOTIFS DE REFÉRENCE AFIN DE DÉTERMINER LA POSITION PRÉCISE DE TOUS LES MOTIFS — 1002

↓

POSITIONNEMENT DE LA TABLE DU MICROSCOPE SUR LE MOTIF DE RANG k — 1003

IIa {

↓

AJUSTEMENT EN MODE MANUEL OU AUTOMATIQUE DE LA LUMIÈRE D'ÉCLAIREMENT ECLAIREMENT CONSTANT DE CHAQUE MOTIF MTij — 1004

↓

ACQUISITION DES VALEURS DE RÉFLECTIVITÉ — 2001

↓

SAUVEGARDE DES DONNÉES — 2002

↓

2003 $\diamond$ K = N — K = k+1

+

↓

LECTURE DES DONNÉES — 3001

↓

TRACER DE LA COURBE DE RÉFLÉCTIVITÉ EN FONCTION DE LA DÉFOCALISATION APPLIQUÉE À CHAQUE MOTIF DE TEST MTij — 3002

IIb {

↓

DÉTERMINATION DE LA VALEUR NOMINALE DU FOCUS PAR UNE MÉTHODE À SEUIL AFFICHAGE $D_e$ TROUVÉ SUR UN ÉCRAN D'ORDINATEUR — 4000

↓

FIN — 5000

FIG.1c.

FOCALISATION DANS LA RÉSINE

FOCALISATION DANS L'AIR

# FIG.2a.

- 2,4~

- 2,1~

- 1,9~

- 1,2~

- 0,9~

- 0,6~

- 0,3~

FOCUS = 0~

+ 0,3~

+ 0,6~

+ 1,2~

+ 1,5~

+ 1,8~

+ 2,1~

+ 2,4~

# FIG.2b.

I →

RÉSINE

SUBSTRAT

# FIG.3.

CNA

1

61

62

10

F

MR

50

51

6

MR

40

MR

41

42

MI

60

4

F

MTij

Pt

Y
X

2

3

FIG.4.

# FIG.5a.

FIG.5b.

F : - 1,2 μ    83°

F : - 1,0 μ    84°

F : - 0,6 μ    84,5°

F : - 0,4 μ    84,5°

F : - 0,2 μ    85°

F : 0 μ    84°

F : + 0,2 μ    85°

F : + 0,4 μ    84°

F : + 0,6 μ    84°

F : + 0,8 μ    83,5°

F : 1,0 μ    82°

F : 1,2 μ    79°